# EUROPÄISCHE PATENTSCHRIFT

(11) **EP 1 466 364 B1**
(45) Veröffentlichungstag und Bekanntmachung des Hinweises auf die Patenterteilung: **30.05.2012**
(21) Anmeldenummer: 03704209.0
(22) Anmeldetag: 14.01.2003
(51) Int. Cl.: H01L 23/31, H01L 21/56

(54) **NUTZEN FÜR ELEKTRONISCHE BAUTEILE SOWIE VERFAHREN ZU DESSEN HERSTELLUNG**
PANEL FOR ELECTRONIC COMPONENTS AND METHOD FOR THE PRODUCTION THEREOF
FLAN POUR COMPOSANTS ELECTRONIQUES ET PROCÉDÉ POUR SA FABRICATION

(30) Priorität: 17.01.2002 DE 10201775
(43) Veröffentlichungstag der Anmeldung: 13.10.2004
(73) Patentinhaber: Qimonda AG, 81739 München (DE)
(72) Erfinder: BLASZCZAK, Stephan, 06632 Freyburg (DE); REISS, Martin, 01109 Dresden (DE)
(74) Vertreter: Patentanwaltskanzlei WILHELM & BECK
(86) Internationale Anmeldenummer: PCT/DE2003/000083
(87) Internationale Veröffentlichungsnummer: WO 2003/060999

(56) Entgegenhaltungen:
- US-A- 6 077 757
- US-A- 6 100 114
- US-A1- 2001 018 229
- US-B1- 6 207 478
- PATENT ABSTRACTS OF JAPAN vol. 2000, no. 13, 5. Februar 2001 (2001-02-05) -& JP 2000 299341 A (ROHM CO LTD), 24. Oktober 2000 (2000-10-24)

## Beschreibung

Die Erfindung betrifft einen Nutzen sowie Verfahren zur Herstellung derselben gemäß der Gattung der unabhängigen Ansprüche.

Elektronische Bauteile, die einen Halbleiterchip und eine auf der Oberseite des Halbleiterchips angeordnete Umverdrahtungsplatte aufweisen, bilden bereits mit diesen Komponenten das Gehäuse des elektronischen Bauteils. Dazu ist lediglich die Umverdrahtungsplatte auf dem Halbleiterchip mit Hilfe einer doppelseitig klebenden Folie aufgebracht. Die Umverdrahtungsplatte trägt die Außenkontakte und eine strukturierte Metallbeschichtung aus Umverdrahtungsleitungen, die von den makroskopischen Ausgangskontakten zu den mikroskopisch kleinen Kontaktflächen der Oberseite des Halbleiterchips in einem Bondkanal der Umverdrahtungsplatte führen. In diesem Zusammenhang wird unter mikroskopisch klein eine Dimension verstanden, die im Mikrometerbereich liegt und folglich nur mit Hilfe eines Lichtmikzoskopes meßbar ist. Während unter den makroskopischen Außenkontakten Dimensionen verstanden werden, die mit bloßem Auge erkennbar und mit einfachen Hilfsmitteln meßbar sind.

Zum Schutz des empfindlichen Halbleiterchips kann die Oberseite der Umverdrahtungsplatte, die mit dem Halbleiterchip verbunden ist, zusätzlich eine Kunststoffgehäusemasse tragen. Diese Kunststoffgehäusemasse kann entweder die Ränder des Halbleiterchips schützen oder den Halbleiterchip vollständig umgeben, wie es aus der Patentschrift US 6,048,755 für BGA-Gehäuse (ball grid array -Gehäuse) bekannt ist. Zum Anbringen derartiger schützender Kunststoffgehäusemassen auf der Oberseite der Umverdrahtungsplatte und zum Einhüllen des Halbleiterchips können entweder Hochdruckspritzgußverfahren eingesetzt werden, die bei Arbeitsdrücken von über 100 bar arbeiten, um Luftblaseneinschlüsse in der Kunststoffgehäusemasse zu vermeiden, oder es können Vakuumprintanlagen eingesetzt werden, um den Rückseitenschutz der Halbleiterchips luftblasenfrei zu gewährleisten. Da bei Vakuumprintanlagen das Aufbringen oder das Bedrucken der Rückseiten der Umverdrahtungsplatte und das Füllen der Zwischenräume zwischen den Halbleiterchips unter Vakuum vorgenommen wird, ist bei diesen Anlagen die Gefahr des Einschlusses von Luftblasen nicht gegeben, da im Vakuum keine Luft vorhanden ist.

Beide Verfahren, die Rückseiten der Halbleiterchips zu schützen, nämlich Verfahren, die unter Vakuum oder bei hohem Druck arbeiten, sind kostenaufwendig, führen aber im Ergebnis zu einem Einhüllen des Halbleiterchips mit einem einzigen kostenaufwendigen Verfahrensschritt. Beide Verfahren beanspruchen darüber hinaus relativ große Zwischenräume zwischen mehreren gleichzeitig in Kunststoffmasse zu verpackenden Halbleiterchips, um eine sicheres luftblasenfreies Einbringen der Kunststoffgehäusemasse um die Halbleiterchips herum zu gewährleisten. Versuche, preiswerte Verfahren anzugeben, die an normaler Luft ein Aufdrucken der Kunststoffgehäusemasse auf die Rückseiten und die Randseiten der Halbleiterchips ermöglichen, scheitern an den Luftblaseneinschlüssen, insbesondere wenn die Zwischenräume zwischen mehreren in Kunststoffgehäusemasse zu verpackende Halbleiterchips wegen zunehmender Dichte pro Bearbeitungsfläche ständig enger werden.

Die US 6,077,757 A offenbart einen Halbleiterchip sowie ein Verfahren zur Herstellung des Halbleiterchips.

Aus der US 6,207,478 B1 ist ein Verfahren zum Herstellen eines Nutzens aus einem Systemträger für mehrere elektronische Bauteile in entsprechenden Positionen mir Halbleiterchips bekannt.

Die US 2001/0018229 A1 beschreibt ein Halbleiterbauelement sowie ein Verfahren zur Herstellung des Halbleiterbauelements.

In der JP 2000299341 A ist ein Verfahren zur Herstellung eines Halbleiterelements offenbart.

Aufgabe der Erfindung ist es, einen Nutzen zu schaffen sowie ein Verfahren zu deren Herstellung anzugeben, wobei das Bauteil eine Struktur aufweist, die es ermöglicht, eine Kunststoffgehäusemasse aufzubringen, bei welcher der Luftblaseneinschluß vermindert ist. Gleichzeitig sollen die Fertigungskosten vermindert werden.

Diese Aufgabe wird mit dem Gegenstand der unabhängigen Ansprüche gelöst. Weiter Ausbildungen der Erfindung ergeben sich aus den Unteransprüchen.

Nach einem Verfahren gemäß der Erfindung wird ein elektronisches Bauteil mit einem Halbleiterchip, einer Umverdrahtungsplatte und einem Kunststoffgehäuse geschaffen, bei dem das Kunststoffgehäuse zwei aufeinander angeordnete Kunststoffgehäusemassen aufweist. Die eine der Kunststoffgehäusemassen bildet eine erste Schicht, die mindestens die Randbereiche des Halbleiterchips vollständig umschließt und die andere der Kunststoffgehäusemassen bildet eine zweite Schicht, die auf der Rückseite des Halbleiterchips angeordnet ist.

Diese Zweiteilung der Kunststoffmasse hat den Vorteil, dass sich am Übergang von einer Kunststoffmasse zur anderen keine mechanisch und hygroskopisch instabile Grenze ausbildet, zumal die Eigenschaften der Kunststoffgehäusemasse in der ersten Schicht an die komplexe Randbereichsstruktur des Halbleiterchips angepaßt werden kann und die zweite Kunststoffgehäusemasse an die Anforderungen eines flächigen Auftrags auf der Rückseite der Halbleiterchips angepaßt ist. Durch Anpassung der Eigenschaften der Kunststoffgehäusemasse in der ersten Schicht können auch komplizierte Strukturen, wie sie im Randbereich von Halbleiterchips auftreten, blasenfrei mit Kunststoff versehen werden. Da eine Grenzphase mit bloßem Auge nicht erkennbar ist, sondern lediglich durch mikroskopische Untersuchung offenbar wird, bleibt das äußere Erscheinungsbild des elektronischen Bauteils für den Abnehmermarkt unverändert, obgleich dieses elektronische Bauteil mit wesentlich preiswerteren Methoden aufgrund der Kombination der Kunststoffgehäusemassen beziehungsweise der Abstimmung ihrer Eigenschaften aufeinander, verbilligt hergestellt ist.

Erfindungsgemäß weist die Kunststoffgehäusemasse der ersten Schicht im nicht vernetzten Zustand eine niedrigere Viskosität auf als die zweite Schicht. Dieses hat den Vorteil, dass die erste niedrigviskose Schicht selbst in enge Zwischenräume zwischen Halbleiterchips eines eng bepackten Systemträgers oder Nutzens mit vielen Bauteilpositionen auf engstem Raum drucktechnisch und blasenfrei eingebracht werden kann.

Da beim Auftrennen des Systemträgers oder Nutzens in Einzelbauteile die Sägespur innerhalb der Zwischenräume verläuft, wird somit bereits mit der ersten in die Zwischenräume eingebrachten Schicht ein Kantenschutz für die Halbleiterchips hergestellt. Ferner wird sichergestellt, dass in diesen Kantenbereichen die Luftblasenbildung aufgrund der niedrigen Viskosität der ersten Schicht aus Kunststoffgehäusemasse im nicht vernetzten Zustand minimiert ist. Ein weiterer Vorteil dieser ersten Schicht der Kunststoffgehäusemasse mit niedriger Viskosität im nicht vernetzten Zustand ist, dass die Kunststoffgehäusemasse derart flüssig ist, dass sie die Ränder der Halbleiterchips benetzt und bei geringen Zwischenräumen zwischen zwei Halbleiterchips aufgrund von Kapillarkräften blasenfrei in den Zwischenraum eingebracht werden kann.

Ein weiterer Vorteil der ersten Schicht mit niedriger Viskosität im nicht vernetzten Zustand ist, dass die Oberfläche aus dieser Kunststoffgehäusemasse äußerst glatt und eben ist. Somit kann sich eine fast ebene Grenzphase zwischen der niedrigviskosen ersten Schicht und einer zähviskosen zweiten Schicht ausbilden. Da bereits durch die erste niedrigviskose Schicht sämtliche Zwischenräume zwischen den Halbleiterchips auf einer Umverdrahtungsplatte aufgefüllt und Höhendifferenzen ausgeglichen sind, kann beim Aufbringen der zweiten zähviskosen Schicht im unvernetzten Zustand eine äußerst ebene und glatte Grenzschicht zwischen den beiden Schichten ohne Ausbildung von Lufteinschlüssen hergestellt werden.

In einer weiteren Ausführungsform der Erfindung unterscheiden sich die Viskositäten der ersten und der zweiten Schicht im nicht vernetzten Zustand derart, dass die Viskosität der ersten Schicht um mindestens eine Größenordnung niedriger ist als die Viskosität der zweiten Schicht. Aufgrund dieses deutlichen Unterschiedes in der Viskosität ist die erste Schicht derart flüssig, dass sie problemlos und luftblasenfrei in äußerst enge Zwischenräume zwischen Halbleiterchips eindringen kann und somit die Randbereiche der Halbleiterchips mit einer Kunststoffmasse benetzen und im vernetzten Zustand schützen kann.

Ein weiterer Aspekt der Erfindung betrifft einen Nutzen mit mehreren Bauteilpositionen für elektronische Bauteile. Der Nutzen weist einen Systemträger auf, der in jeder Bauteilposition eine Bondkanalöffnung aufweist, die mit einer Kunststoffabdeckmasse gefüllt ist. Der Nutzen weist auf der gegenüberliegenden Seite zum Bondkanal mehrere voneinander beabstandete Halbleiterchips in den Bauteilpositionen auf. Die Zwischenräume dieser Halbleiterchips sind mit einer ersten Schicht aus Kunststoffgehäusemasse aufgefüllt und die Rückseiten dieser Halbleiterchips sind mit einer zweiten Schicht aus Kunststoffgehäusemasse bedeckt. Dabei unterscheidet sich die Kunststoffgehäusemasse der ersten Schicht im nicht vernetzteh Zustand von der Kunststoffgehäusemasse der zweiten Schicht dadurch, dass die erste Schicht im nicht vernetzten Zustand eine niedrigere Viskosität aufweist als die zweite Schicht.

Durch diesen Aufbau des Nutzens kann für mehrere Bauteile gleichzeitig der Nutzen mit einer ersten Schicht von niedrigerer Viskosität vergossen oder bedruckt sein und mit einer zähviskosen Schicht können dann die Rückseiten der Halbleiterchips vollständig und luftblasenfrei und gleichzeitig formstabil bedeckt sein. Erst nach dem Aufbringen beider Schichten in einem nicht vernetzten Zustand kann sich ein Temperschritt anschließen, bei dem beide Kunststoffgehäusemassen, sowohl der ersten Schicht als auch der zweiten Schicht unter Beibehaltung einer Grenzphase zwischen den beiden Schichten vernetzen.

Diese Grenzphase ist sowohl bei dem Nutzen als auch bei dem einzelnen elektronischen Bauteil in mikroskopisch kleinen Bereichen durch Schliffbilder der Kunststoffgehäusemasse nachweisbar. In diesem Zusammenhang wird unter mikroskopisch klein ein Maßstab verstanden, der im Mikrometerbereich liegt, wobei Abmessungen nur unter dem Lichtmikroskop feststellbar sind.

Die Viskositäten der ersten Schicht und der zweiten Schicht des Nutzens unterscheiden sich um mindestens eine Größenordnung, so dass die erste Schicht die Zwischenräume zwischen den Halbleiterchips eines Nutzens auch bei äußerst dichter Packungsweise des Nutzens blasenfrei auffüllen kann. Mit einer zähviskosen zweiten Schicht, die nun eine relativ ebene Grenzfläche oder Oberfläche sieht, kann luftblasenfrei eine weitere und formstabile Kunststoffgehäusemasse drucktechnisch aufgebracht werden. Der Vorteil eines solchen Nutzens liegt darin, dass für mehrere Bauteile gleichzeitig eine Kunststoffgehäusemasse aus zwei Komponenten, nämlich einer niedrigviskosen und einer zähviskosen Komponente besteht, die ein luftblasenfreies Kunststoffgehäuse bilden.

Ein Verfahren zum Herstellen des Nutzens aus einem Systemträger für mehrere elektronische Bauteile in entsprechenden Bauteilpositionen mit Halbleiterchip, die von zwei Schichten einer Kunststoffgehäusemasse umhüllt sind, weist folgende Verfahrensschritte auf:
- Bereitstellen eines Systemträgers mit mehreren Bauteilpositionen, die in ihrem Zentrum eine Bondkanalöffnung aufweisen,
- Aufbringen einer doppelseitig klebenden Folie mit Bondkanalöffnung in den Bauteilpositionen,
- Aufbringen von Halbleiterchips mit ihren aktiven Oberseiten auf die doppelseitig klebende Folie,
- Einbringen von Bondverbindungen in jedem Bondkanal zum elektrischen Verbinden von Kontaktflächen des Halbleiterchips mit Außenkontakten auf der Unterseite des Systemträgers,
- Auffüllen des Bondkanals mit einer Kunststoffabdeckmasse,
- Aufdrucken einer ersten Schicht aus niedrigviskoser Kunststoffgehäusemasse auf die Rückseiten der Halbleiterchip zum Auffüllen der Zwischenräume zwischen den Halbleiterchips auf dem Systemträger,
- Abdrucken einer zweiten Schicht aus zähviskoser Kunststoffgehäusemasse zum Abdecken der Rückseiten der Halbleiterchips,
- Aushärten der Kunststoffgehäusemasse zu einer geschlossenen Oberseite des Nutzens unter Bildung einer Grenzphase,
- Aufbringen von Außenkontakten auf der Unterseite des Nutzens.

Dieses Verfahren hat den Vorteil, dass viele Schritte auf dem Weg zur Herstellung eines elektronischen Bauteils parallel für mehrere elektronische Bauteile durchgeführt werden können. Darüber hinaus hat dieses Verfahren den Vorteil, dass die Zwischenräume zwischen den Halbleiterchips und damit die Packungsdichte der Halbleiterchips auf dem Systemträger des Nutzens äußerst eng ausgeführt werden kann, da keine Evakuierung der Zwischenräume zwischen den Halbleiterchips erforderlich ist, sondern vielmehr die niedrigviskose Komponente der ersten Schicht im nicht ausgehärteten Zustand über Kapillarwirkung die Zwischenräume zwischen den Halbleiterchips blasenfrei auffüllen kann.

Weiterhin hat dieses Verfahren den Vorteil, dass mit der ersten niedrigviskosen Schicht eine äußerst ebene Grenzphase zwischen der ersten und der zweiten Schicht aufgebaut werden kann, so dass beim Aufbringen der zähviskosen Schicht keine Luftblasen in die Grenzschicht zwischen niedrigviskoser Schicht und zähviskoser Schicht eingebracht werden. Das Aushärten der beiden Kunststoffgehäusemassen der ersten Schicht und der zweiten Schicht kann gleichzeitig in einem Temperofen erfolgen, so dass eine geschlossene glatte und ebene Oberseite des Nutzens entsteht. Ein Aufbringen von Außenkontakten auf die Unterseite des Nutzens auf jede der Außenkontaktflächen der Unterseite des Systemträgers hat den weiteren Vorteil, dass gleichzeitig und mit einem Schritt eine hohe Anzahl an Außenkontakten auf der Unterseite des Systemträgers eingelötet werden können.

In einem Durchführungsbeispiel des Verfahrens der Erfindung erfolgt das Aufdrucken der ersten und der zweiten Schicht aus niedrigviskoser beziehungsweise zähviskoser Kunststoffgehäusemasse mittels Schablonendruck. Dazu wird eine Schablone, die eine Öffnung aufweist, die so groß ist wie der gesamte Nutzen, auf den Systemträger aufgelegt und eine niedrigviskose Kunststoffgehäusemasse eingebracht und mit Hilfe eines Spatels verteilt. Dabei wird die Kunststoffgehäusemasse teilweise mittels kapillarer Kräfte in die Zwischenräume zwischen den Halbleiterchips ohne Bildung von Luftblaseneinschlüssen eingebracht.

Sowohl beim Aufdrucken der ersten als auch beim Aufdrucken der zweiten Schicht aus niedrigviskoser beziehungsweise zähviskoser Kunststoffgehäusemasse wird ein Spatel eingesetzt, der unter Druck auf die Druckschablone gepreßt wird, um möglichst gleichmäßige und ebene Außenflächen des elektronischen Bauteils beziehungsweise Außenflächen des Gehäuses des elektronischen Bauteils zu erzeugen.

In einem weiteren Durchführungsbeispiel des Verfahrens kann die zweite Schicht aus Kunststoffgehäusemasse, die auf die Rückseiten der Halbleiterchips aufgebracht wird, mit der gleichen Druckschablone aufgebracht werden wie die erste Schicht aus Kunststoffgehäusemasse. Mit diesen Verfahrensschritten wird ein Nutzen für mehrere elektronische Bauteile realisiert, der auf der einen Seite ein komplettes Kunststoffgehäuse aus Kunststoffgehäusemasse aufweist, wobei dieses Gehäuse aus zwei aufeinander liegenden Schichten besteht, die in vorteilhafter Weise luftblasenfrei eingebracht sind, weil die erste Schicht aus einem niedrigviskosen Kunststoffgehäusematerial besteht und die zweite Schicht aus einem zähviskosen Material aufgebaut ist. Die zähviskose Abdeckung der Rückseiten der elektronischen Halbleiterchips bewirkt gleichzeitig, dass die ebene Oberfläche, die bei dem Druckvorgang durch eine Schablone entsteht, während der gesamten Prozessphasen, insbesondere auch beim Aushärtprozess, formstabil beibehalten werden kann.

Ein Verfahren zur Herstellung eines elektronischen Bauteils aus dem Nutzen hat lediglich einen weiteren Schritt zur Folge, nämlich das Zerteilen des Nutzens in einzelne elektronische Bauteile. Dazu wird durch die Zwischenräume, die inzwischen mit niedrigviskosem Kunststoff aufgefüllt sind, mit einer Säge der Nutzen zerteilt, so dass, wenn vorher bereits auch die Außenkontakte auf dem Nutzen aufgebracht sind, ein komplettes elektronisches Bauteil zum Anbringen auf einer übergeordneten Schaltungsstruktur wie einer Leiterplatte zur Verfügung steht. Ein Vorteil dieses Verfahrens ist, dass auf teure Vakuumprintanlagen und auf teure Hochdruckspritzgußanlagen bei dem erfindungsgemäßen Verfahren verzichtet werden kann.

Zusammenfassend kann gesagt werden, dass das Auffüllen des Systemträgers zu einem Nutzen für mehrere elektronische Bauteile mit einer Kunststoffgehäusemasse durch Dispensen oder Printen der tiefer liegenden Bereiche zwischen den Chips mit einer niedrigviskosen und nicht blasenbildenden Kunststoffgehäusemasse erfolgen kann und anschließend der gesamte Nutzen mit einem hochviskosen Kunststoff überdruckt wird. Dieses Überdrucken ermöglicht ein blasenfreies Vergießen der einzelnen Halbleiterchips innerhalb des Nutzens.

Es kann die zuerst aufgebrachte niedrigviskose Vergußmasse oder Kunststoffgehäusemasse bereits ausgehärtet werden oder aber im noch nicht ausgehärteten Zustand mit einer hochviskosen Vergußmasse überdruckt werden. Das Verfahren hat zur Folge, dass die Vakuumprozeßschritte, die sonst beim Vakuumprinten erforderlich sind, .entfallen können. Ferner können für Verfahren, die ein Entgasen der Kunststoffgehäusemasse vorsehen, das langsamere Mehrfachprinten sowie das langsamere Entgasen im Vakuum durch die schnelleren Druckprozesse mit niedrigviskosem Material und mit anschließend zähviskosem Material ersetzt werden.

Außerdem entfällt die für das Evakuieren der Zwischenräume erforderliche Abstandslimitierung, die bei dem Vakuumdruckverfahren zu beachten ist, so dass ein gewisser Oberflächengewinn durch dichtere Bepackung des Systemträgers mit Halbleiterchips ermöglicht ist. Auch das Absacken der Vergußmasse, wenn sie mit nur einem Verfahrensschritt aufgebracht wird, kann durch dieses zweistufige Verfahren verhindert werden. Die Erfindung nutzt somit in vorteilhafter Weise die Verwendung einer Kombination aus niedrigviskosen und hochviskosen Kunststoffgehäusemassen, um mittels eines Mehr-Stufen-Prozesses ein blasenfreies Drucken von Kunststoffgehäusen auf Halbleiterchips zu gewährleisten.

Die Erfindung wird nun anhand von Ausführungsformen mit Bezug auf die beiliegenden Zeichnungen näher erläutert.
- Figur 1: zeigt eine schematischen Querschnittsansicht eines elektronischen Bauteils einer Bauteilposition eines Nutzens einer Ausführungsform der Erfindung,
- Figur 2: zeigt eine Prinzipskizze einer Vorrichtung zum Aufbringen einer ersten Schicht einer Kunststoffgehäusemasse für einen Nutzen,
- Figur 3: zeigt eine Prinzipskizze einer Vorrichtung zum Aufbringen einer zweiten Schicht einer Kunststoffgehäusemasse für einen Nutzen,
- Figur 4: zeigt einen Auszug eines Flußdiagramms zur stufenweisen Herstellung einer Kunststoffgehäusemasse auf einem Nutzen für mehrere elektronische Bauteile.

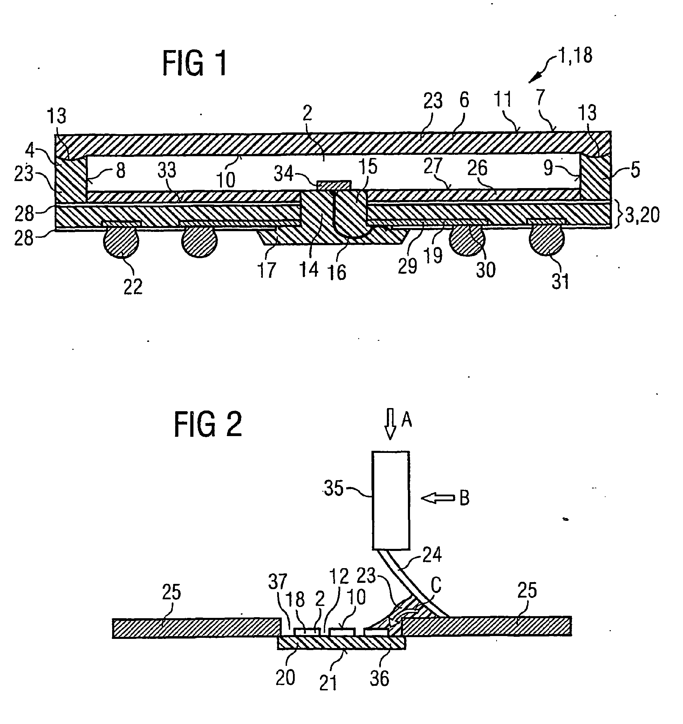

Figur 1 zeigt eine schematische Querschnittsansicht eines elektronischen Bauteils 1 einer Bauteilposition 18 eines Nutzens 36 einer Ausführungsform der Erfindung. Das Bezugszeichen 2 kennzeichnet einen Halbleiterchip, der mit seiner aktiven Oberseite 27 auf einer Umverdrahtungsplatte 3 mittels einer doppelseitig klebenden Folie 26 verbunden ist. Das Bezugszeichen 4 kennzeichnet ein Kunststoffgehäuse, das aus einer ersten Schicht 5 einer Kunststoffgehäusemasse 23 und einer zweiten Schicht 6 einer Kunststoffgehäusemasse 23 aufgebaut ist. Zwischen den Kunststoffgehäusemassen 23 beziehungsweise zwischen der ersten und der zweiten Schicht 5 und 6 bildet sich eine Grenzphase 13 aus, die unter dem Mikroskop sowohl für das elektronische Bauteil 1 als auch für den Nutzen 36 nachweisbar ist.

Das Bezugszeichen 7 kennzeichnet die Außenseiten des Kunststoffgehäuses 4, die sich im wesentlichen bei dieser Ausführungsform der Erfindung, die mittels Druckertechnik ein Kunststoffgehäuse 4 aufbaut, nicht wesentlich von Kunststoffgehäusen 4 unterscheidet, die mittels Hochdruckspritzgußverfahren oder mittels Vakuumdruckverfahren hergestellt wurden. Bei dem Hochdruckverfahren wird ein derart hoher Druck auf die Kunststoffgehäusemasse ausgeübt, dass Luftblasen aus dem Verbund herausgepreßt werden, während beim Vakuumdruckverfahren Luftblasen schon deshalb nicht auftreten, da das ganze Bedrucken in einer Vakuumkammer durchgeführt wird.

Die Bezugszeichen 8 und 9 kennzeichnen die Randbereiche des Halbleiterchips 2, die mindestens von der ersten Schicht 5 aus Kunststoffgehäusemasse 23 umschlossen werden. Das Bezugszeichen 10 kennzeichnet die Rückseite der Halbleiterchips 2 oder des Halbleiterchips 2, die vollständig mit Kunststoffgehäusemasse 23 bedeckt ist, wobei der größte Anteil für diese Kunststoffgehäusemasse 23 eine zähviskose Kunststoffmasse liefert, die in einem zweiten Schritt zu einer zweiten Schicht 6 auf die Rückseiten 10 der Halbleiterchips 2 aufgebracht wird. Das Bezugszeichen 11 kennzeichnet eine geschlossene Oberseite des Nutzens 36, die im wesentlichen die Oberseite der Kunststoffgehäusemasse 23 der zweiten Schicht 6 ist.

Mit dem Bezugszeichen 12 werden die Zwischenräume zwischen den Halbleiterchips 2 eines Nutzens 36 gekennzeichnet. Diese Zwischenräume 12 können äußerst eng gestaltet werden, da die niedrigviskose Kunststoffgehäusemasse 23 im nicht vernetzten Zustand in sehr enge Zwischenräume 12 mittels Kapillarwirkung eindringen kann. Das hat den Vorteil, dass die Packungsdichte der Halbleiterchips 2 auf einem Systemträger 20 vergrößert und verbessert werden kann.Das Bezugszeichen 13 kennzeichnet die bereits oben erwähnte Grenzphase zwischen der ersten niedrigviskosen Schicht 5 und der zweiten zähviskosen Schicht 6 aus Kunststoffgehäusemasse 23.

Auf der der Kunststoffgehäusemasse 23 gegenüberliegenden Unterseite 21 des Systemträgers 20 ist eine Bondöffnung 14 für einen Bondkanal 15 angeordnet. Dieser Bondkanal 15 ist erforderlich, damit die mikroskopisch kleinen Kontaktflächen 34 des Halbleiterchips 2 mit den makroskopischen Außenkontakten 30 auf der Umverdrahtungsplatte 3 verbunden werden können. Dazu sind Bondverbindungen 16 zwischen den Kontaktflächen 34 des Halbleiterchips 2 und den Umverdrahtungsleitungen 19 auf der Unterseite des Systemträgers 20 angeordnet. Die Umverdrahtungsleitungen 19 erstrecken sich vom Bondkanal 15 zu Außenkontaktflächen 30 auf der Unterseite der Umverdrahtungsplatte 3. Diese Außenkontaktflächen 30 tragen Außenkontakte 22, die auf den Außenkontaktflächen 30 auf der Unterseite 21 des Systemträgers 20 angeordnet sind.

An den Übergängen der Bondverbindungen 16 auf die Umverdrahtungsleitungen 19 weisen diese Bondenden oder Bondfinger auf. Diese Bondenden können durch eine Beschichtung veredelt sein. Da die Umverdrahtungsleitungen 19 im wesentlichen aus einer Kupferschicht bestehen, ist für die Veredelung ein kupferdiffusionshemmendes Metall und ein darauf angeordnetes Edelmetall vorgesehen. Das kupferdiffusionshemmende Metall kann Nickel oder Legierungen desselben sein, da durch diese Nikkelschicht kein Kupfer diffundiert. Die Edelmetallschicht kann aus Gold, Silber oder Legierungen derselben bestehen und sorgt für ein reibungsloses Bonden. Durch Aufbringen eines Flußmittels auf die Außenkontaktflächen 30 können auf die Außenkontaktflächen 30.auch Außenkontakte aufgelötet werden.

Die empfindlichen Bondverbindungen 16 können durch Auffüllen des Bondkanals 15 mit einer Kunststoffabdeckmasse 17 geschützt werden. Dabei ist die Höhe der Kunststoffabdeckmasse 17 geringer als die Höhe, mit der die Außenkontakte von der Unterseite der Umverdrahtungsplatte 3 beziehungsweise der Unterseite 21 des Systemträgers 20 abstehen. Der Systemträger 20 selbst, der mehrere Bauteilpositionen 18 aufweist, besteht aus einer Kernplatte 32, die ihrerseits aus glasfaserverstärktem Epoxidharz besteht.

Das elektronische Bauteil 1, wie es in Figur 1 gezeigt wird, weist eine blasenfreie Kunststoffgehäusemasse 23 auf dem Halbleiterchips 2 auf, da ein Einschluß von Luftblasen im Prinzip durch die mehrstufige Aufbringung der Kunststoffgehäusemasse 23 in Form einer ersten niedrigviskosen Gehäusemasse und einer darauf aufgebrachten zähviskosen Gehäusemasse unterbunden ist.

Der Unterschied in der Viskosität zwischen der ersten Schicht 5 aus Kunststoffgehäusemasse 23 und der zweiten Schicht 6 aus Kunststoffgehäusemasse 23 ist mindestens eine Größenordnung. Damit wird sichergestellt, dass die erste Schicht 5 aus Kunststoffgehäusemasse 23 blasenfrei in die. Zwischenräume 12 zwischen die Halbleiterchips 2 eingebracht werden kann, so dass die Randbereiche 8 und 9 des Halbleiterchips 2 mit einer sie umgebenden Kunststoffgehäusemasse 23 geschützt sind. Die zweite zähviskose Schicht 6 deckt im wesentlichen die Rückseiten 10 der Halbleiterchips 2 ab, so dass mit dieser Ausführungsform der Erfindung ein vollständiges Umhüllen der Halbleiterchips 2 gewährleistet ist.

Figur 2 zeigt eine Prinzipskizze einer Vorrichtung zum Aufbringen einer ersten Schicht 5 einer Kunststoffgehäusemasse 23 auf einen Nutzen 36. Komponenten mit gleichen Funktionen wie in Figur 1 werden mit gleichen Bezugszeichen gekennzeichnet und nicht extra erörtert.

Die Vorrichtung, wie sie im Prinzip in Figur 2 gezeigt wird, weist eine Schablone 25 auf, die eine Schablonenöffnung 37 über den Halbleiterchips 2 freiläßt. Ein Spatel 24 wird in Richtung B über die Schablone 25 geführt und streift dabei eine erste niedrigviskose Kunststoffgehäusemasse auf die Öffnung 37 in der Schablone. Dieses niedrigviskose Material verteilt sich in den Zwischenräumen 12 zwischen den Halbleiterchips 2. Da diese Zwischenräume 12 äußerst gering sein können, kann bei einer entsprechend niedrigen Viskosität das Auffüllen der Zwischenräume durch Kapillarwirkung unterstützt werden, durch welche die erste Kunststoffgehäusemasse 23 blasenfrei in die Zwischenräume zwischen den Halbleiterchips 2 eindringt.

Gleichzeitig wird auf den Spatel 24, der in einer Halterung 35 angeordnet ist, in Pfeilrichtung A ein Druck ausgeübt, damit die Öffnung 37 in der Schablone 25 vollständig mit der Kunststoffgehäusemasse der ersten Schicht verfüllt werden kann. Dabei kann auch ein Teil der Rückseiten 10 der Halbleiterchips 2 von der niedrigviskosen Kunststoffgehäusemasse 23 bedruckt werden.

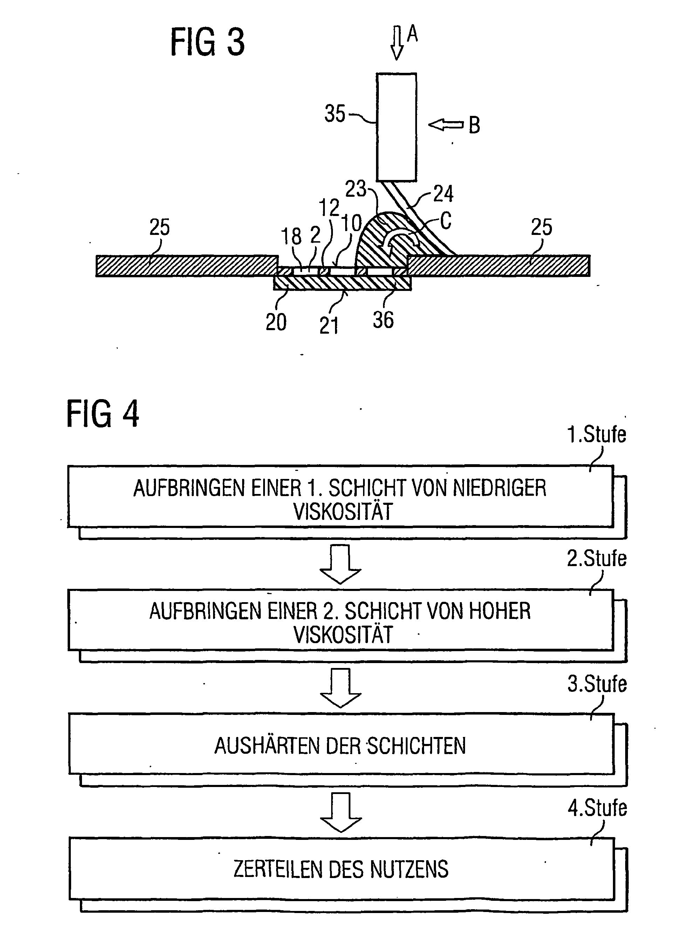

Figur 3 zeigt eine Prinzipskizze einer Vorrichtung zum Aufbringen einer zweiten Schicht 6 einer Kunststoffgehäüsemasse 23 für einen Nutzen 36. Komponenten mit gleichen Funktionen wie in den vorhergehenden Figuren werden mit gleichen Bezugszeichen gekennzeichnet und nicht extra erörtert.

Die Zwischenräume 12 sind beim Einsagtz dieser Vorrichtung bereits aufgefüllt und in Pfeilrichtung B wird nun ein Spatel 24 geführt, der gleichzeitig eine Raupe von zähviskoser Kunststoffgehäusemasse 23 vor sich her schiebt und damit die Rückseiten 10 der Halbleiterchips 2 in den Bauteipositionen 18 abdeckend bedruckt. Diese zähviskose Kunststoffgehäusemasse 23 kann blasenfrei aufgebracht werden, weil die erste Schicht eine äußerst ebene Oberfläche als Grenzphase ausbildet.

Figur 4 zeigt einen Auszug eines Flußdiagramms zur Herstellung einer Kunststoffgehäusemasse 23 auf einem Nutzen 36 für mehrere elektronische Bauteile 1. Das Flußdiagramm umfaßt in der 1. Stufe das Bedrucken der Öffnung in der Schablone und damit das Bedrucken der Halbleiterchips mit einer niedrigviskosen Kunststoffgehäusemasse. Dieses niedrigviskose Kunststoffgehäusematerial wird sich in die Zwischenräume zwischen den Halbleiterchips eines Nutzens einnisten, ohne dass Luftblaseneinschlüsse auftreten.

In der 2.Stufe wird danach ein zweiter Druckvorgang durchgeführt, bei dem eine zähviskose Kunststoffgehäusemasse mit Hilfe des Spatels in die Öffnung der Schablone unter Aufbringen eines Druckes in Pfeilrichtung A auf die in Figur 3 gezeigte Vorrichtung eingedrückt wird.

In der 3. Stufe wird der Kunststoff ausgehärtet mit Hilfe von Temperaturschritten. Dazu kann die niedrigviskose erste Schicht bereits vorgehärtet worden sein, so dass in der 3. Stufe die zähviskose Komponente vernetzt wird.

Die 4. Stufe umfasst das Zerteilen des Nutzens in einzelne elektronische Bauteile.

## Patentansprüche

1. Nutzen im nicht vernetzten Zustand mit mehreren Bauteilpositionen (18) für elektronische Bauteile (1), wobei der Nutzen (36) einen Systemträger (20) aufweist, der in jeder Bauteilposition (18) eine Bondkanalöffnung (14) aufweist, die mit einer Kunststoffabdeckmasse (17) gefüllt ist, und wobei der Nutzen (36) mehrere voneinander beabstandete Halbleiterchips (2) aufweist, deren Zwischenräume (12) mit einer ersten Schicht (5) aus Kunststoffgehäusemasse (23) aufgefüllt sind und deren Rückseiten (10) mit einer zweiten Schicht (6) aus Kunststoffgehäusemasse (23) bedeckt sind, wobei im nicht vernetzten Zustand die erste Schicht (5) eine niedrigere Viskosität aufweist als die zweite Schicht (6).

2. Nutzen nach Anspruch 1, **dadurch gekennzeichnet, dass** sich die Viskositäten der ersten und der zweiten Schicht (5, 6) im nicht vernetzten Zustand derart unterscheiden, dass die Viskosität der ersten Schicht (5) um mindestens eine Größenordnung niedriger ist als die Viskosität der zweiten Schicht (6).

3. Verfahren zum Herstellen eines Nutzens aus einem Systemtrager für mehrere elektronische Bauteile (1) in entsprechenden Bauteilpositionen (18) mit Halbleiterchips (2), die von zwei Schichten (5, 6) einer Kunststoffgehäusemasse (23) umhüllt sind, wobei das Verfahren folgende Verfahrensschritte aufweist:
- Bereitstellen eines Systemträgers (20) mit mehreren Bauteilpositionen (18), die in ihrem Zentrum eine Bondkanalöffnung (14) aufweisen,
- Aufbringen einer doppelseitig klebenden Folie (26) mit Bondkanalöffnung (14) in den Bauteilpositionen (18),
- Aufbringen von Halbleiterchips (2) mit ihren aktiven Oberseiten auf die doppelseitig klebende Folie (26),
- Einbringen von Bondverbindungen (16) in jedem Bondkanal (15) zum elektrischen Verbinden von Kontaktflächen (34) des Halbleiterchips (2) mit Außenkontakten (22) auf der Unterseite (21) des Systemträgers (20),
- Auffüllen des Bondkanals (15) mit einer Kunststoffabdeckmasse (17), die die Bondverbindungen (16) abdeckt,
- Aufdrucken einer ersten Schicht (5) aus niedrigviskoser Kunststoffgehäusemasse (23) auf die Rückseiten der Halbleiterchips (2) zum Auffüllen der Zwischenräume (12) zwischen Halbleiterchips (2) auf dem Systemträger (20),
- Aufdrucken einer zweiten Schicht (6) aus Zähviskoser Kunststoffgehäusemasse (23) zum Abdecken der Rückseiten (10) der Halbleiterchips (2),
- Aushärten der Kunststoffgehäusemasse (23) zu einer geschlossenen Oberseite (11) des Nutzens (36),
- Aufbringen von Außenkontakten (22) auf die Unterseite des Nutzens (36)
wobei im nicht vernetzten Zustand die erste Schicht (5) eine niedrigere Viskosität aufweist als die zweite Schicht (6).

4. Verfahren nach Anspruch 3, wobei das Aufdrucken der ersten und der zweiten Schicht (5, 6) aus Kunststoffgehäusemasse (23) mittels Schablonendruck erfolgt.

5. Verfahren nach Anspruch 3 oder 4, wobei beim Aufdrucken der ersten und der zweiten Schicht (5, 6) Kunststoffgehäusemasse (23) ein Spatel (24) unter Druck auf eine Druckschablone (25) gepresst wird.

6. Verfahren nach einem der Ansprüche 3 bis 5, wobei sich die Viskositäten der ersten und der zweiten Schicht (5, 6) im nicht vernetzten Zustand derart unterscheiden, dass die Viskosität der ersten Schicht (5) um mindestens eine Größenordnung niedriger ist als die Viskosität der zweiten Schicht (6) .

7. Verfahren nach einem der Ansprüche 3 bis 6, wobei die zweite Schicht (6) aus Kunststoffgehäusemasse (23) mit der gleichen Druckschablone (25) aufgebracht wird, wie die erste Schicht (5) aus Kunststoffgehäusemasse (23).

8. Verfahren nach einem der Ansprüche 3 bis 7, wobei zur Herstellung eines elektronischen Bauteils (1) der Nutzen (36) in einzelne elektronische Bauteile (1) getrennt wird.

## Claims

1. Panel in the unlinked state having a plurality of component positions (18) for electronic components (1), wherein the panel (36) comprises a system carrier (20) which in each component position (18) comprises a bonding-channel aperture (14) which is filled with a plastic covering (17), and wherein the panel (36) comprises a plurality of semiconductor chips (2) which are spaced form one another, the intermediate areas (12) of which are filled-up with a first layer (5) of plastic frame material (23) and the reverse sides (10) of which are covered with a second layer (6) of plastic frame material (23), wherein in the unlinked state the first layer (5) comprises a lower viscosity than the second layer (6).

2. The panel according to claim 1, **characterized in that** the viscosities of the first and second layers (5, 6) differ in the unlinked state in such a way that the viscosity of the first layer (5) is by at least one order of magnitude lower than the viscosity of the second layer (6).

3. Method of producing a panel from a system carrier for a plurality of electronic components (1) in corresponding component positions (18) having semiconductor chips (2) which are coated by two layers (5, 6) of a plastic frame material (23), wherein the method comprises the following process steps:
- providing a system carrier (20) having a plurality of component positions (18) that comprise a bonding-channel aperture (14) in their center,
- applying a double-sided-adhesive film (26) having a bonding-channel aperture (14) in the component positions (18),
- applying semiconductor chips (2) to the double-sided-adhesive film (26) with their active upper surfaces,
- introducing bonding connections (16) in each bonding channel (15) for electrically connecting contact surfaces (34) of the semiconductor chip (2) with external contacts (22) on the lower surface (21) of the system carrier (20),
- filling-up the bonding channel (15) with a plastic covering (17) which covers the bonding connections (16),
- printing a first layer (5) of a plastic frame material (23) having a low viscosity onto the reverse sides of the semiconductor chips (2) for filling-up the intermediate areas (12) between semiconductor chips (2) on the system carrier (20),
- printing a second layer (6) of a plastic frame material (23) having a high viscosity for covering the reverse sides (10) of the semiconductor chips (2),
- hardening of the plastic frame material (23) to form a closed upper surface (11) of the panel (36),
- applying external contacts (22) onto the lower surface of the panel (36),
wherein in the unlinked state the first layer (5) comprises a lower viscosity than the second layer (6).

4. The method according to claim 3, wherein printing the first and second layers (5, 6) of plastic frame material (23) is carried out by means of screen printing.

5. The method according to claim 3 or 4, wherein during printing the first and second layers (5, 6) of plastic frame material (23), a spatula (24) is stamped onto a printing template (25) under pressure.

6. The method according to any one of claims 3 to 5, wherein the viscosities of the first and second layers (5, 6) in the unlinked state differ in such a way that the viscosity of the first layer (5) is by at least one order of magnitude lower than the viscosity of the second layer (6).

7. The method according to any one of claims 3 to 6, wherein the second layer (6) of plastic frame material (23) is applied by means of the same printing template (25) as the first layer (5) of plastic frame material (23).

8. The method according to any one of claims 3 to 7, wherein for producing an electronic component (1), the panel (36) is separated into individual electronic components (1).

## Revendications

1. Flan à l'état non réticulé et présentant plusieurs positions (18) prévues pour des composants électroniques (1),
le flan (36) présentant un porte-système (20) doté en chaque position (18) pour composant d'une ouverture (14) de canal de liaison replie d'une pâte (17) de recouvrement en matière synthétique,
le flan (36) présentant plusieurs puces semi-conductrices (2) situées à distance les unes des autres et dont les espaces intermédiaires (12) sont remplis d'une première couche (5) d'une pâte (23) en matière synthétique pour boîtier et dont le côté arrière (10) est recouvert par une deuxième couche (6) d'une pâte (23) en matière synthétique pour boîtier,
la viscosité de la première couche (5) étant inférieure à celle de la deuxième couche (6) à l'état non réticulé.

2. Flan selon la revendication 1, **caractérisé en ce que** les viscosités de la première et de la deuxième couche (5, 6) à l'état non réticulé diffèrent l'une de l'autre par le fait que la viscosité de la première couche (5) est d'au moins un ordre de grandeur plus basse que la viscosité de la deuxième couche (6).

3. Procédé de fabrication d'un flan constitué d'un porte-système pour plusieurs composants électroniques (1) en des positions (18) pour composants, avec des puces semi-conductrices (2) englobées dans deux couches (5, 6) d'une pâte (23) en matière synthétique pour boîtier, le procédé présentant les étapes suivantes :
- préparer un porte-système (20) présentant plusieurs positions (18) pour composants dotées en leur centre d'une ouverture (14) de canal de liaison,
- appliquer un film adhésif double face (26) doté d'une ouverture (14) de canal de liaison dans les positions (18) prévues pour les composants,
- appliquer des puces semi-conductrices (2) dont le côté supérieur actif est situé sur le film adhésif double face (26),
- installer des liaisons (16) dans chaque canal de liaison (15) pour relier électriquement des surfaces de contact (34) de la puce semi-conductrice (2) à des contacts extérieurs (22) situés sur la face inférieure (21) du porte-système (20),
- remplir le canal de liaison (15) d'une pâte (17) de recouvrement en matière synthétique qui recouvre les liaisons (16),
- imprimer une première couche (5) de pâte (23) en matière synthétique pour boîtier à basse viscosité sur la face arrière des puces semi-conductrices (2) de manière à remplir les espaces intermédiaires (12) situés entre les puces semi-conductrices (2) placées sur le porte-système (20),
- imprimer une deuxième couche (6) de pâte (23) en matière synthétique pour boîtier à haute viscosité pour recouvrir la face arrière (10) des puces semi-conductrices (2),
- faire durcir la pâte (23) pour boîtier en matière synthétique de manière à former une face supérieure fermée (11) du flan (36),
- appliquer des contacts extérieurs (22) sur la face inférieure du flan (36),
- la viscosité de la première couche (5) étant inférieure à celle de la deuxième couche (6) à l'état non réticulé.

4. Procédé selon la revendication 3, dans lequel l'impression de la première et de la deuxième couche (5, 6) en pâte (23) de matière synthétique pour boîtier s'effectue par impression au pochoir.

5. Procédé selon les revendications 3 ou 4, dans lequel lors de l'impression de la première et de la deuxième couche (5, 6) de pâte (23) en matière synthétique pour boîtier, une spatule (24) est repoussée sous pression sur un pochoir d'impression (25).

6. Procédé selon l'une des revendications 3 à 5, dans lequel les viscosités de la première et de la deuxième couche (5, 6) à l'état non réticulé diffèrent l'une de l'autre par le fait que la viscosité de la première couche (5) est d'au moins un ordre de grandeur plus basse que la viscosité de la deuxième couche (6).

7. Procédé selon l'une des revendications 3 à 6, dans lequel la deuxième couche (6) de pâte (23) en matière synthétique pour boîtier est appliquée à l'aide du même pochoir d'impression (25) que la première couche (5) de pâte (23) en matière synthétique pour boîtier.

8. Procédé selon l'une des revendications 3 à 7, dans lequel pour fabriquer un composant électronique (1), le flan (36) est découpé en composants électroniques (1) individuels.
